# EUROPEAN PATENT APPLICATION

(11) **EP 0 534 440 A1**
(43) Date of publication of application: **31.03.1993**
(21) Application number: 92116400.0
(22) Date of filing: 24.09.1992
(51) Int. Cl.: H01L 23/44, H01L 23/42, H01L 23/473

(54) **Cooled electronic device**

(30) Priority: 25.09.1991 JP 245963/91
(71) Applicant: HITACHI, LTD., Chiyoda-ku, Tokyo 100 (JP)
(72) Inventor: Ohashi, Shigeo, Tsuchiura-shi (JP); Hatada, Toshio, Tsuchiura-shi (JP); Inouye, Hiroshi, Higashiibaraki-gun, Ibaraki-ken (JP)
(74) Representative: Patentanwälte Beetz - Timpe - Siegfried Schmitt-Fumian - Mayr

(57) **Abstract**

A wiring substrate (2) having a number of semi-conductor elements (1) mounted thereon are contained together with a coolant (3) in a flexible film (6) formed in sack-shape, the sack is then sealed, and a heat transfer member (32) is pressed to the outside of the flexible film (6). A temperature difference between the surface of the semi-conductor element (1) and the heat transfer member-pressed surface of the coolant (3) causes a convection which acts to transmit the heat generated at the semiconductor elements (1) to the heat transfer member (32). Although the heights of the semiconductor elements (1) mounted on the substrate (2) are different from each other, the flexible film (6) formed in sack-shape can be freely transformed so as to be in close contact with the element at every portion irrespective of the different heights thereof, and the cooling operation can desirably be carried out without applying excessive load to the substrate (2) and the semiconductor elements (1).

## Description

### BACKGROUND OF THE INVENTION

### FIELD OF THE INVENTION

This invention relates generally to a cooling means for a substrate, and more particularly to an electronic device comprising a recipient suitable for cooling semiconductor elements and keeping them at a predetermined temperature.

### DESCRIPTION OF THE RELATED ARTS

In a conventional electronic device, as described in Japanese Utility Model Unexamined Publication No. 61-12289, a heat-generating electronic component has been cooled by: filling a sack made of a flexible material with a cooling liquid and sealing it; pressing the sack to the electronic component e.g. a semiconductor element mounted on a wiring substrate; and circulating the cooling liquid in the sack.

It is also possible, as shown in Japanese Utility Model Unexamined Publication No. 62-21543, to compose such that a flexible recipient filled with a cooling liquid and sealed is disposed at both sides of the wiring substrate to be in contact with heat-generating components for cooling them. A space for collecting the generated vapor is provided such that the capacity of the space varies depending on the vapor amount.

In aforementioned conventional devices, the sack formed by the flexible film and filled with the cooling liquid and sealed is pressed to the heat-generating element for transmitting the heat generated at the electronic device through the flexible film to the liquid. Such structure, however, cannot provide desirable cooling effect due to the heat resistance existing at the contact surface of the heat-generating element with the flexible film, and to the heat resistance of the flexible film itself. Further, if the heights of the heat-generating elements greatly differ from each other, it is necessary to use a flexible film having a significantly large flexibility such that the film can closely be in contact with the heat-generating surfaces of all heat-generating elements. However, the reduction of the film thickness for increasing the flexibility would undesirably cause liquid leakage.

In addition, if the device disclosed in the aforementioned Japanese Utility Model Unexamined Publication No. 61-12289 is used to cool electronic components mounted on a wiring substrate having a large flexibility, the substrate could undesirably be transformed by the liquid pressure.

Meanwhile, the device disclosed in the aforementioned Japanese Utility Model Unexamined Publication No. 62-21543 requires a vapor space at the upper portion of the recipient, thereby becoming disadvantageous in capacitive efficiency.

### SUMMARY OF THE INVENTION

It is therefore an object of this invention to provide an electronic device comprising a recipient which is capable of efficiently transmitting heat generated at electronic components e.g. semiconductor elements mounted on a substrate to a heat transfer member for cooling, without applying undesirable load even when the semi-conductor elements have heights different from each other.

A first feature of the present invention to attain above-mentioned object is that: a plurality of semiconductor elements mounted on the substrate of the electronic device are cooled by a coolant; at least one semiconductor element is contained in a recipient made of flexible film and being filled with the coolant; and at least one surface of the recipient opposed to the respective semiconductor element is formed in sack-shape by using a flexible film for receiving the coolant and sealed.

In order to attain the above object, also, an inlet and an outlet for the coolant may be formed in the recipient such that the coolant is circulated inside the recipient by an externally provided coolant circulating means through the inlet and the outlet.

Further, at least one surface of the recipient opposed to the respective semiconductor element may be formed of an electrical conductive material, the recipient contains at least one semiconductor element and is filled with the coolant, and the end portions of the recipient are sealed by the flexible film.

In addition, a heat transfer member may be formed at the outer side of at least one surface of the recipient opposed to the respective semiconductor element.

Furthermore, the coolant may comprise an electrically insulating inert liquid.

The end portions of the flexible film may be joined by fusing the resin layers formed on the flexible film.

Another feature of the present invention is that: the plurality of semiconductor elements mounted on the substrate of the electronic device are cooled by the coolant; the elements are contained inside the recipient made of the flexible film and filled with the coolant; the semiconductor elements are arranged in plane form and coupled to a plurality of wiring materials impregnated in resin; each of the wiring materials is passed outwardly through the respective end portion of the recipient; the resin impregnated with the respective passing wiring material and a resin layer of the flexible film are joined; and an inner electronic circuit and an outer electronic circuit in the recipient are mutually electrically coupled through a respective wiring material.

Yet another feature of the present invention is that, in forming a sack-shape recipient by applying a resin layer in the inner surface of a flexible film and thermally fusing the resin layer at the end portions of the flexible film, a plurality of wiring materials are held between the flexible films at the thermal fusing, and the resin impregnated with the wiring materials is thermally fused to join the end portions of the flexible film.

The flexible film may comprise an electrical conductive layer and a resin layer covering the electrical conductive layer, the electrical conductive layer being electrically coupled to the semiconductor elements.

The semiconductor elements mounted on the substrate may be coupled to a keyboard and a display device, and the recipient may be disposed by being pressed to a space between a casing wall on which the keyboard and the display device are mounted and a substrate supporting the keyboard, or a space formed between the casing wall and the display device.

Yet another feature of the present invention is that, in a computer, a plurality of electronic circuit substrates having a plurality of semiconductor elements mounted thereon are contained together with a coolant and arranged in a plurality of recipients respectively, and cooling member which is cooled by water circulation or by refrigerator is disposed to be pressed to each recipient.

The above and other advantages, features and additional objects of this invention will be manifest to those versed in the art upon making reference to the following detailed description and accompanying drawings in which the structural embodiment incorporating the principles of this invention is shown by way of example.

### BRIEF DESCRIPTION OF THE DRAWINGS

FIG. 1 is a perspective partial sectional view showing a first embodiment of this invention;
FIG. 2 is a perspective view showing an essential part in FIG. 1;
FIG. 3 is a sectional view showing a second embodiment of this invention;
FIG. 4 is a sectional view showing a third embodiment of this invention;
FIG. 5 is a schematic view showing a fourth embodiment of this invention;
FIG. 6 is a sectional view showing a fifth embodiment of this invention;
FIG. 7 is a plan view of the fifth embodiment shown in FIG. 6;
FIG. 8 is a partial sectional view of a modification of the fifth embodiment shown in FIG. 6;
FIG. 9 is a partial sectional view of another modification of the fifth embodiment shown in FIG. 6;
FIG. 10 is a perspective view showing a sixth embodiment of this invention;
FIG. 11 is a plan view showing a seventh embodiment of this invention.

### DESCRIPTION OF THE PREFERRED EMBODIMENTS

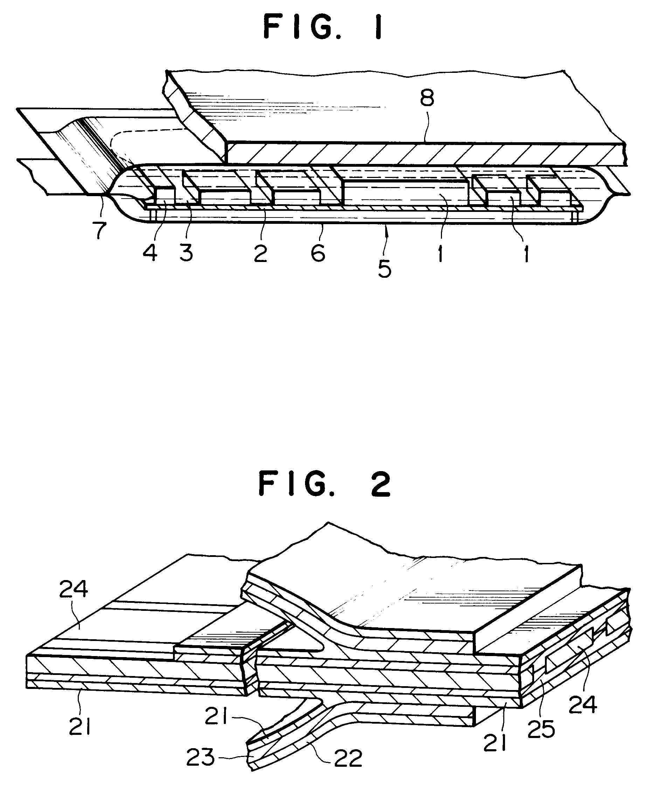

A first embodiment of the present invention will now be described. As shown in FIG. 1, a wiring substrate or a substrate 2 having a number of semi-conductor elements mounted thereon is contained in a recipient 5 made of a flexible film 6 such as a sack-shape film. A cooling fluid 3 as a coolant is filled in the sack-shape recipient 5. As a cooling fluid 3, an electrically insulating inert liquid of perfluoro-carbon family and so on is used. A heat transfer member 8 is pressed to the outer surface of the recipient 5, facing the surface of the semiconductor element 1. The signal input/output to an electronic circuit composed of semiconductor elements contained in the sack-shaped recipient 5 is carried out through a plurality of wiring materials 7 having high electrical conductivity via a connector 4. Due to the temperature difference between the surface of the semiconductor element 1 and the inner surface of the flexible film 6 to which the heat transfer member 8 is pressed, a convection is generated in the cooling fluid 3 thereby to promote the conductivity of the heat generated in the semiconductor element 1. Thus, the heat is eventually transmitted to the heat transfer member 8 to be emitted outwardly. Even when the semiconductor elements 1 are mounted on both sides of the wiring substrate 2, the cooling function can be carried out by pressing the heat transfer member 8 to both sides of the sack-shaped recipient 5.

In this embodiment, although the semiconductor elements 1 and electronic components mounted on the wiring substrate 2 are of different heights, it is possible to perform cooling function desirably irrespective of the height difference without applying excessive load to the wiring substrate 2 and the semiconductor elements 1, since the recipient is filled with the cooling fluid 3. Further, even when only a particular semiconductor element 1 is locally generating heat, an efficient cooling can be carried out, since the heat can be transferred by making use of large surface on which the heat transfer member 8 is pressed.

FIG. 2 shows a signal input/output portion of the device of the first embodiment. In this embodiment, the flexible film comprises of a multi-layered film including resin layers 21, 22 of different melting temperatures, and a metallic layer (conductive layer) 23 made of metallic film such as Aluminum or the like. The flexible film is formed in sacked-shape by thermally fusing the resin layers 21 of the two film at its end portions. At this time, the surfaces of the resin layer 21 having the lower melting temperature are mutually faced, and the end portions are heated and fused at a temperature where only the inner resin layer 21 is melted. The wiring materials 24 made of e.g. copper are arranged in parallel and impregnated in resin 25, and the thermally-fused resin layer 21 is provided on its surface. At the end portions, the wiring material 24 is exposed to be electrically coupled to the connector. The layer to be thermally fused is the flexible film, which is of the same material as of the resin layer 21 melting at a lower temperature. The flexible film is thermally fused integrally with the wiring materials 24 when forming a sack-shaped recipient.

In this embodiment, since the metallic layer 23 is formed as an inner layer of the flexible film, it is possible to prevent the electromagnetic wave generated in the electronic circuit on the wiring substrate from being leaked externally. The metallic layer 23 is electrically earthed to the electronic circuit e.g. the wiring substrate.

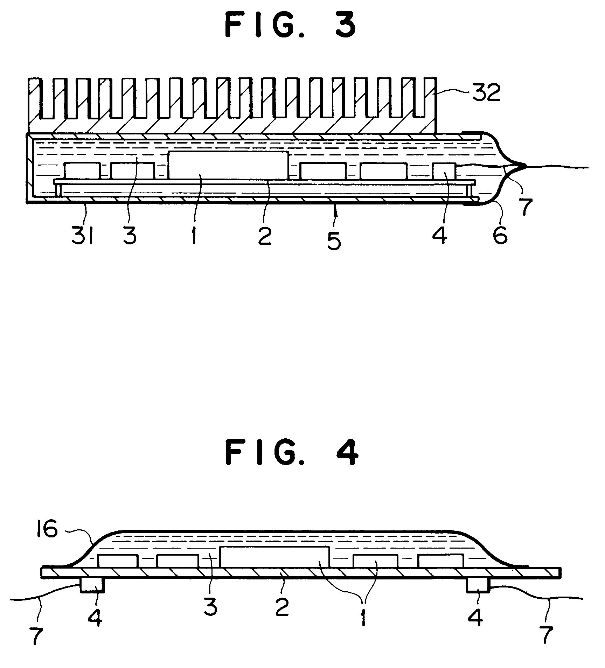

Second and third embodiments of the present invention will now be described with reference to FIGS. 3 and 4, respectively. In FIG. 3, a wiring substrate 2 mounting the semiconductor element 1 is disposed in a metallic recipient 31 of an electrical conductive material, which is filled with a cooling fluid 3 and has an opening sealed by a flexible film 6. The electrical coupling to the wiring substrate 2 in the recipient 31 is made through a wiring material 7 being integrated with the flexible film 6 by thermal fusion. A heat transfer member 32 is provided at the outer surface of the metallic recipient 31. The heat generated in the semi-conductor element 1 is transmitted to the recipient wall by the convection of the cooling fluid, and transferred by the heat transfer member 32 formed on the outer wall of the recipient 5. Although in the second embodiment a fin is formed as the heat transfer member 32, it is also possible to adopt a heat transfer by forced air-cooling method or a direct heat transfer using a water-cooling jacket. The heat transfer member 32 can also be integrated with the recipient wall 5 of the metallic recipient 31. In the second embodiment, since there is a metallic wall between the cooling fluid 3 and the heat transfer member 32, it is possible to carry out the transfer of the heat at the heat transfer member 32 with a small heat resistance.

FIG. 4 shows the third embodiment of this invention where a flexible film 16 is joined to only the surface mounting the semiconductor element 1 of the substrate 2 and filling the cooling fluid 3 therein. The flexible film 16 is joined by thermal fusion or by using adhesive agent etc. According to this embodiment, it is possible to input/output the signals through the connector 4 and the wiring materials 7 from the reverse surface of the wiring substrate 2. The flexible film 16 can be formed limitedly to the region around an semi-conductor element or semiconductor elements having particularly large heat-generating amount on the wiring substrate 2. Further, a reliable electronic device can be realized by coating the surface of the wiring substrate 2 with an insulating thin film so that the wiring substrate 2 and the semiconductor elements 1 can be protected from the cooling fluid 3.

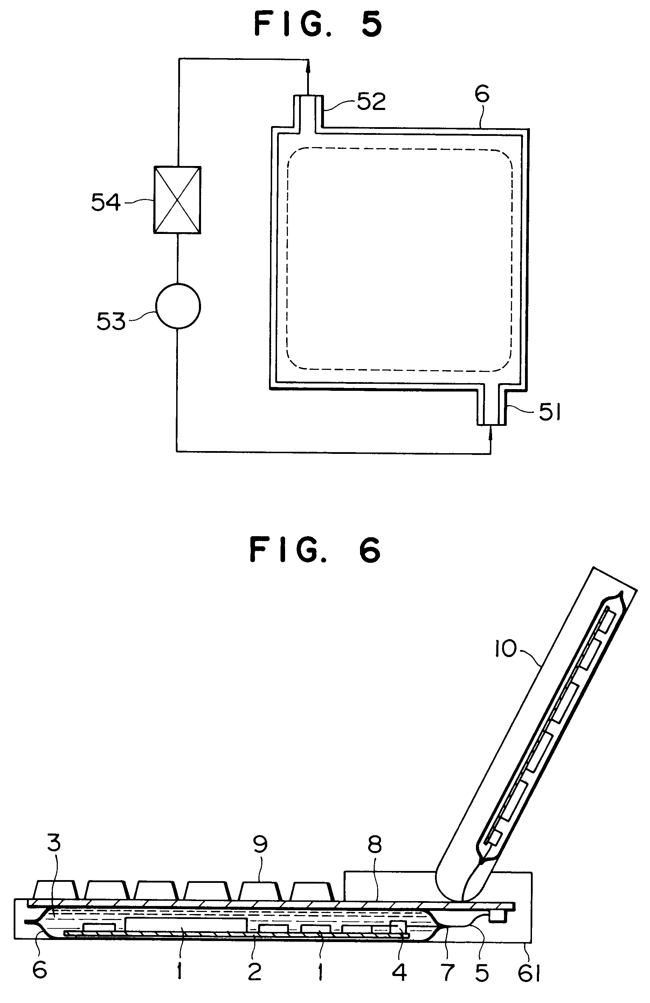

FIG. 5 is a schematic view showing a fourth embodiment of this invention. In this embodiment, the wiring substrate together with the cooling fluid are sealed in the sack-shaped flexible film 6, which is provided with an inlet 51 and an outlet 52 for the cooling fluid that is circulated by a pump 53 as a coolant circulating means. In addition, a heat exchanger 54 is disposed in a flowing path between the outlet 52 and the pump 53 such that the heat generated in the semiconductor elements can be transferred outwardly, thereby providing a high cooling property.

A fifth embodiment of this invention is shown in FIG. 6. In this embodiment, the electronic device is a computer composed of a wiring substrate 2 having semiconductor elements 1 mounted thereon, a keyboard 9 and a display device 10 etc., and the wiring substrate 2 is sealed in the flexible film 6 together with the cooling fluid 3. The flexible film 6 is disposed between a supporting plate 8 for supporting the keyboard 9 and the wall of the casing 61, and pressed to the wall surface by the pressure of the sealed coolant. The input of the signal from the keyboard to the wiring substrate 2, and the output of the signal from the wiring substrate 2 are carried out through a connector 4 and wiring materials 7 integrally formed with the flexible film 6. Further, it is also possible to seal the wiring substrate 2 for display and the illuminating section of the display device 10 within the sack-shaped flexible film 6 together with the cooling fluid.

The sack-shaped flexible film 6 is formed in multilayered structure comprising a resin layer used for the thermal fusion and a metallic film layer e.g. aluminum, and can provide an electromagnetic shielding effect. The metallic film layer is electrically earthed to the wiring substrate 2. The supporting substrate 8 of the keyboard 9 is made of metallic material, and the wiring of the keyboard 9 is carried out by forming film-type wiring materials on the upper surface of the supporting plate 8. The heat generated in the semi-conductor elements 1 is transmitted to the supporting plate 8 of the keyboard 9 by the convection of the sealed cooling fluid 3, and then transferred toward the external atmosphere. On the other hand, also at the wiring substrate 2 for display the heat is transmitted to the casing surface side within the sack due to the convection of the cooling fluid, and then transferred through the casing surface of the back side of the display section in contact with the flexible film 6. In this embodiment, in a case where the space allowed for cooling is significantly limited, it is possible to efficiently cool the heat-generating components on the wiring substrate even the semiconductor elements and the electronic components have heights different from each other.

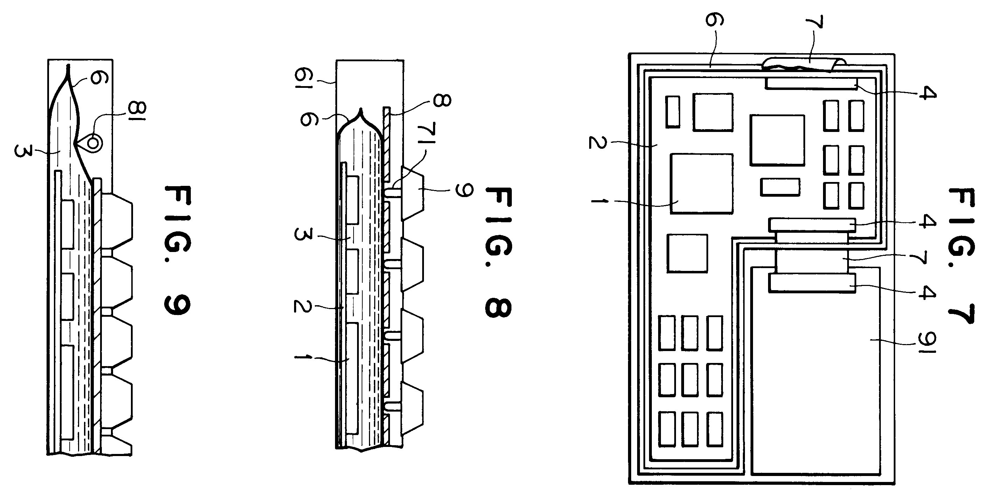

Further, as shown in FIG. 7, since the wiring substrate 2 can be formed in a desired configuration, an external memory device 91 can surely located in a small area. In this case, the flexible film 6 is formed by thermally fusing two films having a shape corresponding to that of the wiring substrate 2 at their end portions. The electrical coupling of the wiring substrate to the external memory device 91 and the other circuits is carried out through a connector 4 and a wiring materials 7 integrated with the sack-shaped flexible film 6.

Modifications of the fifth embodiment of the device shown in FIG. 6 are shown in FIGS. 8 and 9. As shown in FIG. 8, the sack-shaped flexible film 6 containing the wiring substrate 2 and the cooling fluid 3 is disposed between the casing 61 and the supporting plate 8 for the keyboard. A convex member 7 is disposed on the lower surface side of the keyboard 9. When a key is depressed, the convex portion 71 of the lower end portion of the keyboard passes through a hole portion formed in the supporting plate 8 for the keyboard so as to press the flexible film 6. At this time, the flexible film 6 is transformed, and the sealed cooling fluid 3 moves. Due to this movement of the cooling fluid 3, the natural convection generated between the surface of the semiconductor elements 1 and the lower surface of the substrate contained in the sack becomes turbulent to promote the heat transmission. Thus, the heat transfer of the semiconductor elements 1 can be effectively performed. Further, as shown in FIG. 9, it is also possible to provide a rotating mechanism including a cam 81 in order to forcibly move the cooling fluid 3 by supplying vibration to the flexible film 6.

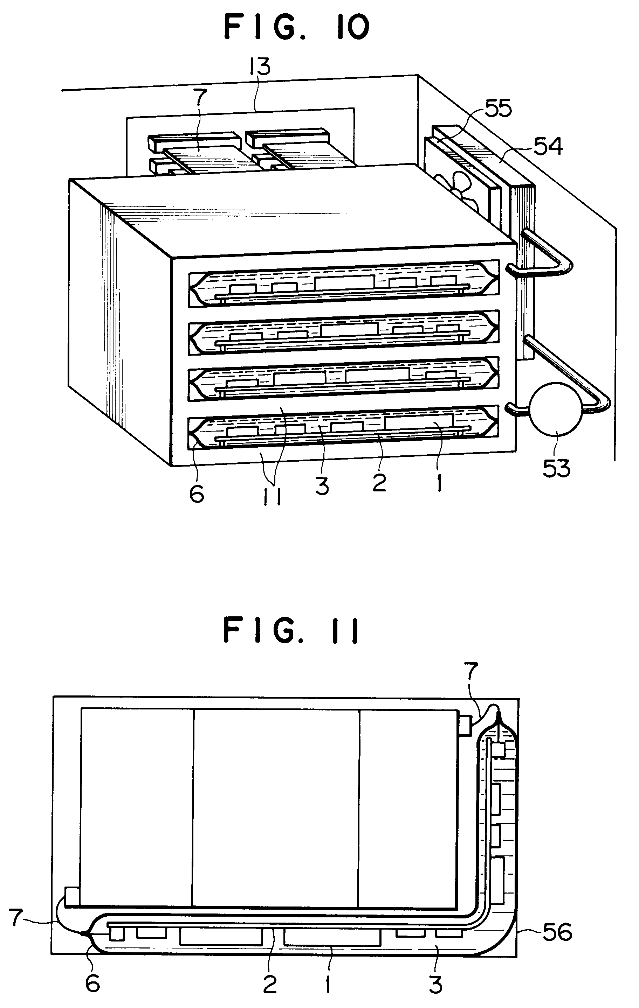

FIG. 10 shows a sixth embodiment of an electronic device composed of a plurality of wiring substrates 2 mounting a number of semiconductor elements 1. Each wiring substrate 2 is contained and sealed in the sack-shaped flexible film 6 together with the cooling fluid 3, and disposed and pressed between the cooling plates 11 as cooling members. Each wiring substrate 2 is electrically coupled to the back board 13 through the connector and the wiring materials 7. The cooling plate 11 has a cooling water path formed therein, the pump 53 and the heat exchanger 54 are connected thereto for circulating the cooling water therethrough. The heat generated in the semiconductor elements 1 is transmitted toward the cooling plate by the convection of the cooling fluid in the sack-shaped flexible film 6, and then transported by the circulating cooling water, and eventually heat-exchanged by the heat exchanger 54 to be transferred outwardly. A forcible cooling by a fan 55 can also be adopted depending on the capacity of the heat exchanger. It is also possible to incorporate a refrigeration cycle, using the cooling plate as a evaporator in the refrigeration cycle.

A seventh embodiment is shown in FIG. 11, where in an electronic device, the semiconductor elements 1 are mounted on a flexible wiring substrate 2 having a wiring layer formed on a resin film in a space within a casing. In this embodiment, the wiring substrate 2 is curved and disposed in an L-shaped space along a casing wall 56. The wiring substrate is contained in the sack-shaped flexible film 6 together with the cooling fluid 3, the sack-shaped film itself being then curved to be disposed in the space within the casing. The heat generated in the semiconductor elements 1 is externally transferred through the casing wall 56 by the convection of the cooling fluid 3 in the flexible film 6. According to this embodiment, it is possible to effectively use the space due to the capability of transforming the sack-shaped flexible film to desired configuration, and to effectively perform the cooling of the semiconductor elements.

In view of above, according to the present invention, since the substrate is contained in a recipient formed by the flexible film, the heat generated in the semiconductor elements mounted on the substrate can be efficiently transmitted to the heat transfer member for cooling even within a space with limited configuration and area, without applying excessive load. Further, it is also possible to absorb the fluctuation of the volume of the electrically insulating liquid due to the change of the liquid temperature. In addition, the signals can be electrically input/output freely through a flexible film-free surface, by forming the flexible film only at one side of the substrate. Moreover, since the coolant contained in the recipient together with the substrate mounting the semiconductor elements is conducted to the heat exchanger for heat exchange between the coolant and the external cooling heat source, the heat generated in the semiconductor elements can be efficiently cooled.

## Claims

1. An electronic device including a recipient (5) made of a flexible film for receiving a coolant (3) for cooling at least one semiconductor element mounted on a substrate (2), wherein said recipient (5) contains at least one semi-conductor element (1) therein.

2. An electronic device according to claim 1, wherein at least one surface of said recipient (5) opposed to the semi-conductor element (1) contained in said recipient (5) is formed of a flexible film (6) in sack shape, and the coolant (3) is supplied into the recipient (5) and said sack-shaped surface is sealed.

3. An electronic device according to claim 1, wherein said recipient (5) is formed by joining the respective end of the flexible film (6) to the surface of the substrate mounting at least one semiconductor element (1), and the coolant (3) is supplied to a space formed by the flexible film (6) and the substrate (2) which is then sealed.

4. An electronic device according to claim 1, wherein an inlet (51) and an outlet (52) for the coolant (3) are formed in said recipient (5), a coolant circulating means (53) is provided outside the recipient (5), and said coolant circulating means (53) and said recipient (5) in cooperation form a closed flowing path for circulating the coolant (3) in said recipient (5).

5. An electronic device according to claim 1, wherein at least one surface of said recipient (5) opposed to the semi-conductor element (1) contained therein is formed of an electrical conductive material, and the coolant (3) is supplied to the recipient (5) with the respective ends being sealed by means of flexible films.

6. An electronic device according to claim 1, wherein at least one part of the outside of the surface of the recipient (5) opposed to the semiconductor element (1) contained therein is provided with a heat transfer member (32).

7. An electronic device according to claim 1, wherein said coolant (3) comprises an electrically insulating inert liquid.

8. An electronic device according to claim 1, wherein the respective ends of said flexible film (6) is formed in sack-shape by thermally melting a resin layer (21, 22) formed on the surface of the flexible film (6).

9. An electronic device according to claim 1, wherein said plurality of semiconductor elements (1) are arranged in flat plane design and coupled to a plurality of wiring materials (7) impregnated in resin, said plurality of wiring materials (7) passing through said recipient (5) at its end portions, said resin impregnated with said plurality of wiring materials (7) passing through the recipient (5) and the resin layer (21, 22) formed on the surface of the flexible film (6) being jointed.

10. An electronic device including a recipient (5) made of a flexible film (6) for receiving a coolant (3) for cooling at least one semiconductor element (1) mounted on a substrate (2), wherein
a resin layer (21, 22) is formed on the surface of the flexible film (6);
the peripheral portion of the flexible film (6) of the recipient (5) is formed in sack-shape by thermally fusing its resin layer (21, 22);
at least one semiconductor element (1) is contained in a space within the recipient (5) and electrically coupled to a wiring material (7); and
the resin impregnated with the wiring material (7) is held by the flexible film (6) at its peripheral portion, the both ends of the flexible film (6), and the flexible film (6) and the resin impregnated with the wiring material (7) are thermally fused to each other respectively, thereby forming said recipient (5).

11. An electronic device according to claim 10, wherein said flexible film (6) comprises an electrical conductive layer (23) and a resin layer (21, 22) covering the electrical conductive layer (23), which is electrically coupled to the semiconductor element (1) contained in the recipient (5).

12. An electronic device according to claim 10, wherein said at least one semiconductor element (1) mounted on the substrate (2) is coupled to a keyboard (9) and a display device (10), and said recipient (5) is disposed in one of a space between a casing wall on which the keyboard (9) and the display device are mounted and a plate (8) supporting the keyboard (9), and a space between the casing wall and the display device (10).

13. An electronic device according to claim 10, wherein
said electronic device is a computer;
a plurality of electronic circuit substrates (2) mounting a plurality of semiconductor elements (1) are arranged and contained together with coolant (3) in a plurality of recipients (5), respectively; and
one of a circulating means (53) for circulating the coolant (3) and a cooling member cooled by a refrigerator (54) is thermally coupled to the respective recipient (5).

14. An electronic device according to claim 10, wherein said substrate (2) is a flexible substrate, which is contained in said recipient (5).

15. An electronic device according to claim 10, wherein a movable member is mounted in contact with the flexible film portion of the recipient (5) so as to transform the flexible film.
